# EUROPÄISCHE PATENTSCHRIFT

(11) **EP 2 842 714 B1**
(45) Veröffentlichungstag und Bekanntmachung des Hinweises auf die Patenterteilung: **16.05.2018**
(21) Anmeldenummer: 14181191.9
(22) Anmeldetag: 15.08.2014
(51) Int. Cl.: B29C 45/14, H05K 5/02

(54) **Druckausgleichselement**
Pressure equalising element
Élément d'équilibrage de pression

(30) Priorität: 16.08.2013 EP 13180704
(43) Veröffentlichungstag der Anmeldung: 04.03.2015
(73) Patentinhaber: Oxyphen AG, 8620 Wetzikon (CH)
(72) Erfinder: Kaiser, Ulrich, 88267 Vogt (DE)
(74) Vertreter: Clerc, Natalia

(56) Entgegenhaltungen:
- EP-A2- 0 328 038
- WO-A1-2012/147241
- GB-A- 2 348 622

## Beschreibung

### TECHNISCHES GEBIET

Die vorliegende Erfindung betrifft ein luftdurchlässiges Druckausgleichselement mit einem selbstdichtenden Hüllkörper und einer darin eingelegten Filtermembran.

### STAND DER TECHNIK

Geschlossene Geräte, wie beispielsweise Scheinwerfer von Kraftfahrzeugen oder Elektronik-Steuergeräte, weisen in ihrem Inneren meist Wärmequellen auf. Diese Wärmequellen führen zu einer Ausdehnung der Luft im Inneren des Gehäuses. Daraus resultiert ein Luftaustausch. Um zu vermeiden, dass durch diesen Luftaustausch Umweltschmutz in das Innere des Gehäuses gelangt, besteht eine Möglichkeit darin, das Gehäuse hermetisch dicht zu gestalten und dadurch den Luftaustausch gänzlich zu verhindern. Da teilweise jedoch durch die Ausdehnung erhebliche Drucke entstehen können, erfordert ein hermetischer Verschluss einen erheblichen technologischen und mechanischen Aufwand.

Eine andere Möglichkeit besteht darin, den Gehäuseinnenraum zu belüften beziehungsweise einen Gasaustausch zu erlauben. Ein erlaubter Gasaustausch erfordert es jedoch, dass Massnahmen getroffen werden, durch die Umwelteinflüsse von dem Innenraum des geschlossenen Gerätes fern gehalten werden. Üblicherweise wird dazu der Innenraum des geschlossenen Gerätes dicht gestaltet und nur in klar definierten Stellen werden gezielt Belüftungsöffnungen eingebracht. Diese Belüftungsöffnungen werden dann mit einem luftdurchlässigen Verschlusselement oder Druckausgleichselement verschlossen. Die Vermeidung von Umwelteinflüssen, wie beispielsweise Spritzwasser, wird dabei dadurch bewerkstelligt, dass das Druckausgleichselement mit einer Filterscheibe oder Filtermembran versehen ist, durch die ein Gasaustausch möglich ist, die jedoch zumindest Staubpartikel und Flüssigkeiten nicht durchlässt. Die Belüftungsöffnungen bestehen aus zumeist kreisrunden Löchern in der Gehäusewand. In diese Löcher können die Verschlusselemente eingesteckt werden. Die Löcher können jedoch auch mit einem Dom versehen werden, auf welchen ein Verschlusselement aufgesteckt werden kann.

Solche Druckausgleichselemente werden in grosser Anzahl, zum Beispiel im Automobilbau, eingesetzt und tragen massgeblich zur Lebensdauer der Geräte bei, in welchen sie zur Anwendung kommen. Trotz ihrer Wichtigkeit dürfen diese Druckausgleichselemente nicht viel kosten. Eine kostengünstige Herstellung ist daher von grossem Vorteil.

Die US 5,522,769 offenbart ein Druckausgleichselement, welches einstückig hergestellt wird und eine umspritzte Filtermembran aufweist. Die Filtermembran-Abdeckung wird im aufgeklappten Zustand mit dem Hüllkörper zusammen gespritzt und muss für den Gebrauch umgeklappt werden. Nachteilig an einer solchen Ausführungsform sind die zusätzlich benötigten Schritte für die Fertigstellung. Das Umklappen der Filtermembran-Abdeckung bedingt zusätzliche Arbeitsschritte, die die Herstellung verteuert. Einen weiteren Nachteil stellen die Bereiche dar, an welchen die Filtermembran-Abdeckung umgeklappt wird. Um das Umklappen zu erleichtern, sind diese Bereiche dünner als der Rest ausgebildet. Die dünneren Bereiche sind leichter beschädigbar, vor Allem beim Umklappen der Filtermembran-Abdeckung sowie bei der Montage.

Die EP 1 970 258 offenbart ein Druckausgleichselement mit einer separat hergestellten Abdeckung und einer Filtermembran, welche auf einem umlaufenden Sims des Hüllkörpers aufliegt. Nachteilig an einer solchen Ausführungsform ist, dass der separate Deckel auf dem Hüllkörper angeordnet und mit diesem verbunden werden muss. Dies erfordert zusätzliche Fertigungsschritte.

Die EP 2 202 117 offenbart einen einstückigen Hüllkörper, jedoch ohne Filtermembran-Abdeckung. Die Filtermembran ist auf einem ringförmigen Membranträger angeordnet, wobei der Membranträger auf einem umlaufenden Sims des Hüllkörpers aufliegt. Ein Problem derartiger Druckausgleichselemente ohne Filtermembran-Abdeckung ist, dass die Filtermembran nicht gegen Spritzwasser und äussere mechanische Einflüsse geschützt ist.

GB 2 348 622 zeigt ein Filter mit auf beiden Seiten aufgespritzten Filterplatten. EP 0 328 038 zeigt ein Kleinfilter in einem Kunststoffgehäuse.

### DARSTELLUNG DER ERFINDUNG

Es ist eine Aufgabe der vorliegenden Erfindung, ein Druckausgleichselement mit Filtermembran bereitzustellen, welches einfach und kostengünstig herstellbar ist, und bei welchem die Filtermembran gegen die direkte Einwirkung von Spritzwasser und äussere mechanische Einflüsse geschützt ist.

Diese Aufgabe wird gemäß der Erfindung gelöst durch ein Druckausgleichselement wie es im Anspruch 1 angegeben ist. Außerdem wird ein Verfahren zur Herstellung eines Druckausgleichelements im Anspruch 19 angegeben. Weitere Ausführungsformen sind in den abhängigen Ansprüchen angegeben.

Das erfindungsgemäße Druckausgleichselement weist einen selbstdichtenden Hüllkörper und eine darin eingelegte Filtermembran auf. Die Filtermembran ist mit mindestens einem Teil des Hüllkörpers mindestens auf zwei Seiten umspritzt, wobei die Filtermembran eigenständig oder auf einem Membranträger angeordnet ausgebildet sein kann. Die Filtermembran ist von einer Filtermembran-Abdeckung des Hüllkörpers überdeckt, wobei die Filtermembran-Abdeckung in ihrer Einbaulage, auch Gebrauchsposition genannt, gespritzt ist. Dieses Druckausgleichselement lässt sich mit einem Minimum an Arbeitsschritten und somit äusserst kostengünstig herstellen. Die Abdeckung bildet eine geschlossene Fläche, so dass von oben kein Wasser in das Druckausgleichselement gelangen kann.

In bevorzugten Ausführungsformen ist der Hüllkörper einstückig ausgebildet ist, wobei die Filtermembran auf allen Seiten mit dem Hüllkörper umspritzt ist und wobei die Filtermembran vom gesamten Hüllkörper umspritzt ist.

Der Hüllkörper weist radial über seinen Umfang verteilte Öffnungen auf, welche mit dem Innenraum des Hüllkörpers einen Luftkanal bilden. Es ist mindestens eine solche Öffnung vorhanden. Es können zwei, drei, vier, fünf, sechs oder mehr solcher Öffnungen vorhanden sein. Die Öffnungen sind vorzugsweise gleichmässig über den Umfang verteilt, sie können aber auch ungleichmässig verteilt sein. Vorzugsweise weisen alle diese Öffnungen die gleichen Abmessungen auf, es ist jedoch denkbar, Öffnungen mit unterschiedlichen Abmessungen auszugestalten. Die Form der Öffnungen ist vorzugsweise rechteckig, sie kann jedoch auch rund, oval, quadratisch oder vieleckig ausgebildet sein. Die radiale Anordnung der Öffnungen schützt die Membran optimal vor Spritzwasser oder äusserer mechanischer Einwirkung. Die Kanalgrösse ist vorzugsweise so gestaltet, dass keine Kapillarwirkung entsteht.

Vorzugsweise unterteilt die Filtermembran den Luftkanal des Druckausgleichselements in einen radialen und in einen axialen Bereich, wobei sich der mindestens eine Radialkanal im Wesentlichen in einer radialen Richtung des Druckausgleichselements erstreckt und sich der Axialkanal im Wesentlichen in der axialen Richtung des Druckausgleichselements erstreckt. Die Anordnung der Filtermembran über dem Axialkanal hat den Vorteil, dass nur eine einzige solche Membran eingesetzt werden muss. Da sich die Filtermembran parallel zu den Radialkanälen erstreckt, wird Spritzwasser, welches durch einen Radialkanal eintritt, nicht durch die Filtermembran behindert und begünstigt somit das Austreten des eingetretenen Spritzwassers auf einer anderen Seite als die Eintrittsseite. Die Filtermembran kann jedoch auch so angeordnet werden, dass auf beiden Seiten der Filtermembran axial verlaufende Luftkanalabschnitte vorhanden sind. Wird die Filtermembran im Axialkanal angeordnet, kommt Spritzwasser, welches durch einen Radialkanal eintritt, nicht direkt mit der Filtermembran in Kontakt. Ausserdem ist die Membran noch besser vor äusseren mechanischen Einwirkungen geschützt.

Vorzugsweise ist die Membran auf einem Membranträger angeordnet. Dies weist den Vorteil auf, dass die Membran beim Einlegen in die Spritzgussform durch den Träger verstärkt ist. Die Gefahr einer Verletzung der Membran während der Herstellung und somit die Ausschussquote bei der Herstellung ist minimiert. Zudem ist die Membran auch beim Einbau des Druckausgleichselements besser geschützt, insbesondere wenn der Hüllkörper gesamthaft weich und kompressibel ausgestaltet ist. Der Membranträger kann ebenfalls vom Hüllkörper umspritzt sein oder er kann einen Teil des Hüllkörpers bilden. Der Membranträger bildet dabei vorzugsweise selber einen Teil des Luftkanals. Dies hat den Vorteil, dass die Formstabilität des Luftkanals erhöht wird.

In einer einfacheren Ausführungsform kann die Filtermembran jedoch auch ohne Membranträger in den Hüllkörper eingesetzt werden. Dadurch wird ein Einzelteil weniger benötigt und die Anordnung der Filtermembran auf dem Membranträger entfällt. Dies führt zu einer Reduktion der Produktionszeit und der Herstellkosten. Vorzugsweise wird die Filtermembran umspritzt oder mit dem Hüllkörper zusammen vergossen.

Der Membranträger ist vorzugsweise einstückig ausgebildet.

Die Auflagefläche der Filtermembran ist auf einer dem mindestens einen Radialkanal abgewandten Seite des Membranträgers angeordnet. Dadurch ist die Filtermembran nicht fluchtend mit einer Wand eines Radialkanals. Dies hat den Vorteil, dass eintretendes Spritzwasser nicht direkt auf die Filtermembran gelangen kann und dass die Filtermembran noch besser vor äusseren mechanischen Einwirkungen geschützt ist. Vorzugsweise wird die Filtermembran mit dem Membranträger verklebt oder verschweisst. Die Filtermembran zusammen mit dem Membranträger bildet eine in sich stabile Einheit, welche in den Hüllkörper einlegbar ist. Vorzugsweise wird die Filtermembran zusammen mit dem Membranträger umspritzt oder mit dem Hüllkörper zusammen vergossen.

In einer einfachen Ausführungsform ist der Membranträger ringförmig ausgebildet. Er kann jedoch auch scheibenförmig sein oder die Form einer dicken Scheibe mit Luftkanal und seitlichen Öffnungen aufweisen. Ist der Membranträger scheibenförmig ausgebildet und weist keine Öffnungen auf, so muss er aus einem gaspermeablen Material gefertigt sein, um sicher zu stellen, dass ein Gas, vorzugsweise Luft, durch die Filtermembran hindurch gelangen kann. Vorzugsweise ist der Grundriss des Membranträgers kreisförmig. Er kann jedoch auch die Form eines Vier-, Fünf-, Sechs- oder Vielecks aufweisen.

In einer bevorzugten Ausführungsform weist der Membranträger radial über seinen Umfang verteilte Öffnungen auf, welche mit dem Innenraum des Membranträgers einen Luftkanal bilden. Der Luftkanal des Membranträgers weist mindestens einen Radialkanal und einen Axialkanal auf. Die Radialkanäle, bzw. der Axialkanal des Membranträgers sind mit den Radialkanälen, bzw. mit dem Axialkanal des Hüllkörpers ausgerichtet. Im Allgemeinen sind Anzahl, Verteilung und Form der Öffnungen des Membranträgers mit denen des Hüllkörpers abgestimmt.

Der Querschnitt des mindestens einen Radialkanals des Membranträgers kann gleich gross sein wie der entsprechende Querschnitt des mindestens einen Radialkanals des Hüllkörpers. In diesem Fall fluchten alle Seitenflächen eines Radialkanals des Membranträgers mit denjenigen des Hüllkörpers.

In einer bevorzugten Ausführungsform ist der Querschnitt des mindestens einen Radialkanals des Membranträgers bezüglich des mindestens einen Querschnitts des Radialkanals des Hüllkörpers eingeschränkt.

Eine kanalseitige Fläche des Membranträgers, welche einen Teil des Luftkanals bildet, kann fluchtend mit einer Wand eines Radialkanals des Hüllkörpers angeordnet sein. Es können auch alle kanalseitigen Flächen des Membranträgers, welche einen Teil des Luftkanals bilden, fluchtend mit den entsprechenden Wänden eines Radialkanals des Hüllkörpers angeordnet sein.

Eine kanalseitige Fläche des Membranträgers, welche einen Teil des Luftkanals bildet, kann versetzt zu einer Wand eines Radialkanals angeordnet sein. Es können auch alle kanalseitigen Flächen des Membranträgers, welche einen Teil des Luftkanals bilden, fluchtend mit den entsprechenden Wänden eines Radialkanals des Hüllkörpers angeordnet sein. Dies hat vor allem bei einer einfachen Ausführungsform, mit einem ringförmigen Membranträger, den Vorteil, dass die Herstellung des Druckausgleichselements besonders einfach wird.

Die Wände des Axialkanals des Membranträgers können fluchtend oder versetzt zu den Wänden des Axialkanals des Hüllkörpers ausgebildet sein. Durch die Wahl des Querschnittverhältnisses vom Axialkanal des Membranträgers zum Axialkanal des Hüllkörpers sowie durch die Anordnung der Kanäle lassen sich die Strömungsverhältnisse im Luftkanal des Druckausgleichselements beeinflussen.

Der Axialkanal des Membranträgers kann in einem zentralen Kanalbereich des Membranträgers über eine Kanalseitenfläche des mindestens einen Radialkanals des Membranträgers ragen. Dies hat zur Folge, dass sich der Querschnitt des Luftkanals wie folgt verändert: vom Querschnitt des zentralen Kanalbereichs über den Querschnitt des Radialkanals des Membranträgers zum Querschnitt des Radialkanals des Hüllkörpers, wobei der Querschnitt des Radialkanals des Membranträgers kleiner ist als derjenige des zentralen Kanalbereichs und derjenige des Radialkanals des Hüllkörpers.

Die Filtermembran oder die Filtermembran zusammen mit dem Membranträger sind in einer umlaufenden Vertiefung des Hüllkörpers angeordnet. Vorzugsweise wird bei der Herstellung die Filtermembran bzw. die Filtermembran mit dem Membranträger in die Spritzform eingelegt und mit dem Material des Hüllkörpers umspritzt.

Der Hüllkörper des Druckausgleichselements besteht vorzugsweise aus einem flexiblen, elastischen, hydrophoben Material, vorzugsweise aus Silikon. Ebenso können auch thermoplastische Elastomere verwendet werden. Der Hüllkörper kann mittels herkömmlicher Formgebungstechniken, beispielsweise Spritzgiessen hergestellt werden. In einer anderen Ausführungsform besteht der Hüllkörper mindestens teilweise aus einer Hartkomponente. In einer Ausführungsform besteht ein Kopfteil des Hüllkörpers, welcher die Filtermembran-Abdeckung bildet, aus einer Hartkomponente und ein Halsteil des Hüllkörpers, auf welchem die Filtermembran aufliegt, besteht aus einer Weichkomponente. Hart- und Weichkomponenten sind vorzugsweise Kunststoffe.

Die Filtermembran ist luftdurchlässig und bis zu einem definierten Druck flüssigkeitsundurchlässig und besteht aus einem hydrophoben, porösen Material, vorzugsweise ist die Membran eine hydrophobe RoTrac® Track-Etched Membran. Die Track-Etched Membran besteht aus einem hydrophilen oder hydrophoben Material, vorzugsweise aus Polyester, Polycarbonat, Polyvinylidenfluorid oder Polyimid und wird im Falle eines hydrophilen Materials über ein Beschichtungsverfahren hydrophobiert. Die Hydrophobierung kann sowohl über das im Patent DE 195 36 033 beschriebene Verfahren oder durch andere geeignete Verfahren aufgebracht werden. Vorzugsweise besteht die hydrophobierende Beschichtung aus fluorhaltigen organischen oder anorganischen Verbindungen. Alternativ könne auch Membrane aus Polytetrafluorethylen (PTFE) oder hydrophobierten Copolymeren verwendet werden.

Der Membranträger besteht vorzugsweise aus einem unflexiblen Material, vorzugsweise aus einem korrosionsbeständigen Metall, aus Kunststoff oder verstärktem Kunststoff. In anderen Ausführungsformen ist er aus einem weichen und/oder flexiblen Material gefertigt, insbesondere aus einem Kunststoff.

Vorzugsweise weist der Membranträger eine zur Filtermembran ähnliche Wärmedehnung auf und ist weder korrosions- noch oxidationsanfällig sowie in einem Temperaturbereich von minus 55°C bis plus 130°C beständig. Beispielsweise besteht der Membranträger aus Aluminium, einer Aluminiumlegierung, einem rostfreien Stahl, Polyethylen, Polyethylenterephthalat (PET) oder aus Silikon. Der Membranträger besteht vorzugsweise aus einem hydrophoben und/oder oleophoben Material.

Ein vorzugsweises Verfahren zur Herstellung eines erfindungsgemässen Druckausgleichselements weist die folgenden Schritte auf:
- Einlegen der Filtermembran in die Spritzform
- Schliessen der Spritzform
- Spritzen des Hüllkörpers bei gleichzeitigem Umspritzen der Membran und bei gleichzeitigem Spritzen der Filtermembran-Abdeckung in ihrer Gebrauchsposition.
- Öffnen der Spritzform
- Entnehmen des Druckausgleichselements

In einem bevorzugten alternativen Verfahren wird die Filtermembran vorgängig auf einem Membranträger angebracht und dann zusammen mit diesem in die Spritzform eingelegt.

### KURZE BESCHREIBUNG DER ZEICHNUNGEN

Bevorzugte Ausführungsformen der Erfindung werden im Folgenden anhand der Zeichnungen beschrieben, die lediglich zur Erläuterung dienen und nicht einschränkend auszulegen sind. In den Zeichnungen zeigen:
- Fig. 1: eine perspektivische Darstellung einer ersten Ausführungsform eines erfindungsgemässen Druckausgleichselements mit der Blickrichtung von unten;
- Fig. 2: eine perspektivische Darstellung des Druckausgleichselements gemäss Figur 1 mit der Blickrichtung von oben;
- Fig. 3: eine zentrale Schnittansicht des Druckausgleichselements gemäss Figur 1;
- Fig. 4: eine perspektivische Darstellung einer Filtermembran mit einem Membranträger des Druckausgleichselements der ersten Ausführungsform;
- Fig. 5: eine perspektivische Darstellung des Membranträgers gemäss Figur 4;
- Fig. 6: eine perspektivische Darstellung einer zweiten Ausführungsform eines erfindungsgemässen Druckausgleichselements mit der Blickrichtung von unten;
- Fig. 7: eine perspektivische Darstellung des Druckausgleichselements gemäss Figur 6 mit der Blickrichtung von oben;
- Fig. 8: eine zentrale Schnittansicht des Druckausgleichselements gemäss Figur 6;
- Fig. 9: eine perspektivische Darstellung einer Filtermembran mit einem Membranträger des Druckausgleichselements gemäss Figur 6;
- Fig. 10: eine perspektivische Darstellung des Membranträgers gemäss Figur 9;
- Fig. 11: eine perspektivische Darstellung einer dritten Ausführungsform eines erfindungsgemässen Druckausgleichelements mit der Blickrichtung von oben;
- Fig. 12: eine perspektivische Darstellung des Druckausgleichselements gemäss Figur 11 mit der Blickrichtung von unten;
- Fig. 13: eine zentrale Schnittansicht des Druckausgleichselements gemäss Figur 11;
- Fig. 14: eine perspektivische Darstellung einer Filtermembran mit einem Membranträger des Druckausgleichselements gemäss Figur 11;
- Fig. 15: eine perspektivische Darstellung des Membranträgers gemäss Figur 14;
- Fig. 16: eine perspektivische Darstellung einer vierten Ausführungsform eines erfindungsgemässen Druckausgleichelements mit der Blickrichtung von oben;
- Fig. 17: eine perspektivische Darstellung des Druckausgleichselements gemäss Figur 16 mit der Blickrichtung von unten;
- Fig. 18: eine zentrale Schnittansicht des Druckausgleichselements gemäss Figur 16;
- Fig. 19: eine perspektivische Darstellung einer Filtermembran mit einem Membranträger des Druckausgleichselements gemäss Figur 16 und
- Fig. 20: eine perspektivische Darstellung des Membranträgers gemäss Figur 16.

### BESCHREIBUNG BEVORZUGTER AUSFÜHRUNGSFORMEN

In den nachfolgend beschriebenen Ausführungsformen sind gleiche, ähnliche oder ähnlich wirkende Merkmale jeweils mit den gleichen Bezugszeichen versehen.

Die in diesem Text verwendeten Begriffe "rechts", "links", "oben" und "unten" beziehen sich auf die Darstellung gemäss den Abbildungen.

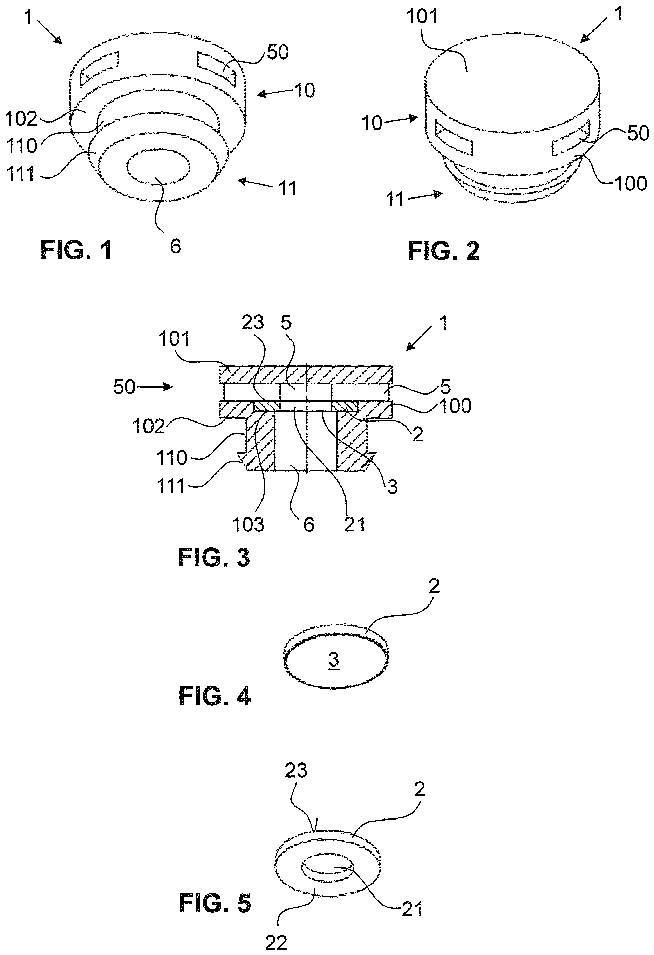

Die Figuren 1 und 2 zeigen eine perspektivische Darstellung einer ersten Ausführungsform eines erfindungsgemässen Druckausgleichselements bzw. luftdurchlässigen Verschlusselements mit der Blickrichtung von unten bzw. von oben. Das Druckausgleichselement weist einen einstückigen, im Wesentlichen rotationssymmetrischen Hüllkörper 1 auf. Der Hüllkörper 1 weist in axialer Richtung grundsätzlich zwei Abschnitte auf: einen oberen Kopfteil 10 und einen unteren Halsteil 11.

Vorzugsweise sind Kopf- und Halsteil aus demselben Kunststoff gefertigt und weich. In anderen Ausführungsformen kann jedoch auch ein Teil, insbesondere der Kopfteil, aus einer Hartkomponente und der andere Teil, insbesondere der Halsteil, kann aus einer Weichkomponente bestehen. Dasselbe gilt auch für die weiter unten im Text beschriebenen drei weiteren Ausführungsformen.

Der Halsteil 11 ist vorzugsweise zentrisch unterhalb des Kopfteils 10 angeordnet. Er weist einen Halsbereich 110 auf, welcher im Wesentlichen kreiszylinderförmig gestaltet ist und welche an den Kopfteil 10 angrenzt. Der Halsbereich 110 kann jedoch auch andere Formen aufweisen. Der Halsbereich 110 geht in einen Rückhaltebereich 111 über, welcher ein freies Ende aufweist. Der Rückhaltebereich weist vorzugsweise die Form einer Auskragung auf. Vorzugsweise ist der Rückhaltebereich 111 so ausgebildet, dass er zum freien Ende hin konisch zusammenläuft. Der Rückhaltebereich kann jedoch auch anders, beispielsweise im Querschnitt halbkreisförmig, ausgebildet sein.

Der Kopfteil 10 ist vorzugsweise kreiszylinderförmig gestaltet. Er kann jedoch auch andere Formen aufweisen. Der Kopfteil 10 wird oben durch eine Aussenfläche einer vorzugsweise kreisförmigen Filtermembran-Abdeckung 101 begrenzt. Auf der dieser Aussenfläche der Filtermembran-Abdeckung 101 gegenüberliegenden Seite des Kopfteils 10 wird dieses durch eine Auflagefläche 102 begrenzt. Vorzugsweise ist diese Auflagefläche 102 ringförmig ausgebildet. Aussen wird diese Auflagefläche 102 durch die äusseren Abmessungen des Kopfteils 1 begrenzt und innen durch die äusseren Abmessungen des Halsbereichs 110.

Der Kopfteil 10 weist radial über seinen Umfang verteilte Öffnungen 50 auf. Diese werden auf ihrer Oberseite durch die Filtermembran-Abdeckung 101 begrenzt und auf ihrer Unterseite durch einen Hüllkörper-Auflagebereich 100. Vorzugsweise ist die Wandstärke der Filtermembran-Abdeckung 101 im Wesentlichen gleich gross wie diejenige des Hüllkörper-Auflagebereichs 100. Vorzugsweise ist die Höhe einer solchen Öffnung 50 gleich gross wie die Wandstärke der Filtermembran-Abdeckung 101 bzw. des Hüllkörper-Auflagebereichs 100.

Im eingebauten Zustand liegt der Kopfteil 10 mit der Auflagefläche 102 auf einem hier nicht dargestellten Gehäuse auf. Der Halsteil 11 wird im eingebauten Zustand in eine hier nicht dargestellte Bohrung des Gehäuses eingeführt. Weist das Gehäuse eine Wandstärke auf, die grösser als die Länge des Halsbereichs 110 ist, so liegen der Halsbereich 110 und der Rückhaltebereich 111 innerhalb der Bohrung und der Rückhaltebereich 111 klemmt radial in der Bohrung. Weist das Gehäuse eine Wandstärke auf, die gleich oder kleiner als die Länge des Halsbereichs 110 ist, so wird das Gehäuse zwischen der Auflagefläche 102 und dem Rückhaltebereich 111 gehalten.

Die Figur 3 zeigt eine zentrale Schnittansicht der Figur 1 oder 2 durch die seitlich am Hüllkörper 1 radial über seinen Umfang verteilten Öffnungen 50. Vorzugsweise weist das Druckausgleichselement innerhalb des Hüllkörpers 1 einen koaxial zu diesem angeordneten, rotationssymmetrischen Membranträger 2 und eine koaxial zum Membranträger 2 angeordnete rotationssymmetrische Filtermembran 3 auf. Der Membranträger 2 sowie die Filtermembran 3 können jedoch auch anders ausgebildet und angeordnet sein. Der Membranträger ist vorzugsweise steif ausgebildet und bildet eine Hartkomponente, vorzugsweise aus Kunststoff. In anderen Ausführungsformen ist er weich und/oder flexibel ausgebildet und bildet eine Weichkomponente, vorzugsweise aus Kunststoff. Dasselbe gilt auch für die Membranträger der anderen in diesem Text beschriebenen Ausführungsbeispiele.

Die Öffnungen 50 bilden mit dem Innenraum des Hüllkörpers 1 einen Luftkanal 5, 6. Die Filtermembran 3 ist derart angeordnet, dass sie den Luftkanal in einen Bereich mit Radialkanälen 5 und in einen Bereich mit einem Axialkanal 6 unterteilt. In der hier dargestellten Ausführungsform sind zwei sich senkrecht kreuzende, durchgehende Radialkanäle 5 mit rechteckigen Querschnitten ausgebildet, wobei die Breite der Radialkanäle 5 grösser ist als ihre Höhe. Vorzugsweise ist die Kanalbreite doppelt, insbesondere dreimal so gross wie die Kanalhöhe. In einer alternativen Ausführungsform sind die Radialkanäle so ausgebildet, dass sie sich nicht kreuzen, sondern dass sie aneinander angrenzend, versetzt zueinander und unter einem Winkel zueinander angeordnet sind. In einer weiteren Ausführungsform ist die Breite der Radialkanäle 5 kleiner als ihre Höhe.

Der Hüllkörper 1 weist eine umlaufende Vertiefung auf, welche vorzugsweise die gleichen Abmessungen aufweist wie die Filtermembran 3 zusammen mit dem Membranträger 2. Die Vertiefung wird in axialer Richtung, an ihrer Unterseite, durch eine Membran-Auflagefläche 103 begrenzt und an ihrer Oberseite durch die Unterseite der Radialkanäle 5. Die Filtermembran 3 liegt auf der Membran-Auflagefläche 103 auf. Der Membranträger 2 ist oberhalb der Filtermembran 3 angeordnet. Die Filtermembran 3 sowie die zwei sich gegenüberliegenden Oberflächen des Membranträgers 2 sind im Wesentlichen plan ausgebildet. Die Dicke des Membranträgers 2 ist vorzugsweise kleiner als, insbesondere halb so gross wie, die Wandstärke des Hüllkörper-Auflagebereichs 100. Die Dicke des Membranträgers 2 ist vorzugsweise um ein Vielfaches grösser als die Dicke der Filtermembran 3. Der Membranträger 2 und die Filtermembran 3 sind vollständig durch die Filtermembran-Abdeckung 101 überdeckt. Der Axialkanal 6 ist nach unten hin offen und erstreckt sich nach oben bis zur Membran-Auflagefläche 103.

Der Membranträger 2 bildet zumindest teilweise selber einen Teil des Luftkanals 5, 6. Eine kanalseitige Oberfläche 23 des Membranträgers 2 ist fluchtend mit einer Wand des Radialkanals 5 des Hüllkörpers 1 ausgebildet. Der Membranträger 2 weist eine vorzugsweise kreiszylinderförmige, zentrale Durchgangsöffnung 21 auf, welche koaxial zum Axialkanal 6 angeordnet ist und sich über die gesamte Dicke des Membranträgers erstreckt. Die zentrale Durchgangsöffnung 21 kann jedoch auch andere Formen aufweisen. Vorzugsweise ist der Querschnitt der zentralen Durchgangsöffnung 21 kleiner als derjenige des Axialkanals 6. Er kann jedoch auch gleich gross ausgebildet sein. Vorzugsweise ist der Durchmesser der zentralen Durchgangsöffnung 21 gleich gross wie die Breite der Radialkanäle 5. Er kann jedoch auch kleiner oder grösser ausgebildet sein.

Werden die in der Figur 3 quer verlaufenden Radialkanäle 5 aus der Richtung der linken Öffnung 50 mit einem Gas durchströmt, so wird Gas aus den quer zu diesen Kanälen verlaufenden Radialkanälen 5 und der Durchgangsöffnung 21 angesogen. Dies bewirkt, dass Schmutz oder Flüssigkeiten, welche sich auf der Filtermembran 3 befinden, zusammen mit dem Gas abgeführt werden.

Die Figur 4 zeigt eine perspektivische Darstellung der Filtermembran 3 mit Membranträger 2 der ersten Ausführungsform und die Figur 5 zeigt eine perspektivische Darstellung des Membranträgers 2 der ersten Ausführungsform. Die Filtermembran 3 ist auf einer Auflagefläche 22 des Membranträgers 2 angeordnet. Vorzugsweise ist die Filtermembran 3 mit dieser Auflagefläche 22 des Membranträgers 2 verbunden, d.h. verklebt oder verschweisst.

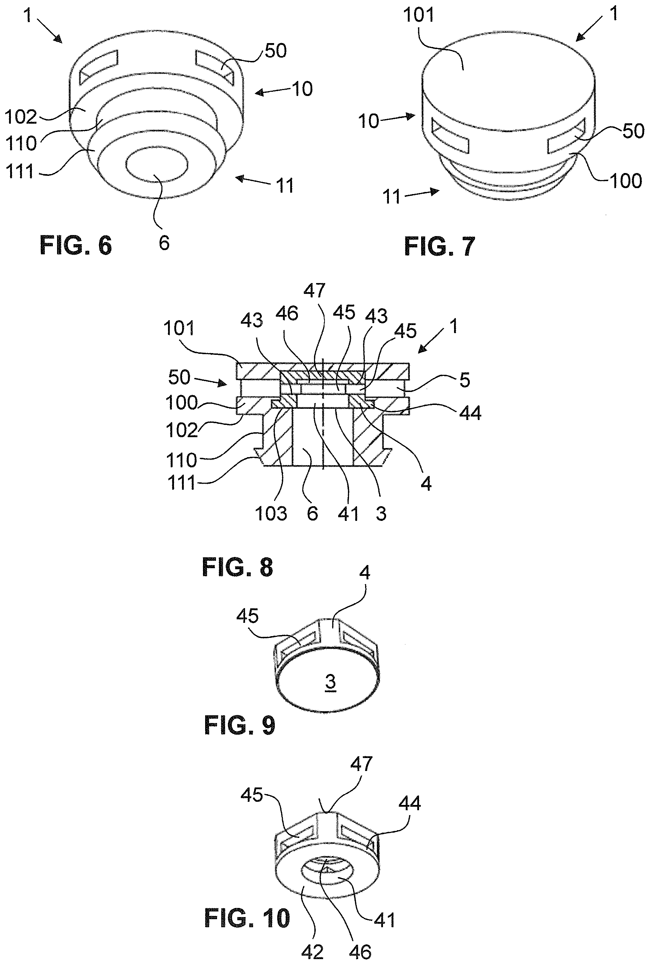

Die Figuren 6 bis 10 zeigen perspektivische Darstellungen einer zweiten Ausführungsform eines erfindungsgemässen Druckausgleichselements mit der Blickrichtung von unten bzw. von oben. Wie gemäss den Figuren 6 und 7 erkennbar ist, weist diese zweite Ausführungsform keine Unterschiede zur ersten Ausführungsform auf, wie sie in den Figuren 1 und 2 dargestellt ist. Wie in Figur 8 erkennbar ist, ist auch in dieser zweiten Ausführungsform ein rotationssymmetrischer Membranträger 4 und eine vorzugsweise koaxial zum Membranträger 4 angeordnete Filtermembran 3 vorhanden. Die Filtermembran 3 wird, wie in Figur 9 dargestellt, ebenfalls an der Unterseite des Membranträgers 4 befestigt.

Im Unterschied zur ersten Ausführungsform weist der Membranträger 4, wie in der Figur 10 dargestellt, die Form einer im Wesentlichen dicken Scheibe auf, mit radial über seinen Umfang verteilten Radialkanälen 45 und mit einer in axialer Richtung verlaufenden zentralen Durchgangsöffnung 41, welche zusammen mit den Radialkanälen 45 einen Luftkanal 45, 41 bilden. Die Membran-Auflagefläche 103 der zweiten Ausführungsform ist im Wesentlichen an der gleichen Stelle angeordnet wie bei der ersten Ausführungsform. Der Membranträger erstreckt sich von der Membran-Auflagefläche 103 aus in Achsrichtung nach oben über annähernd die gesamte Höhe des Kopfteils 1. In der Filtermembran-Abdeckung ist eine Ausnehmung ausgebildet, um den oberen Teil des Membranträgers 4 darin aufzunehmen. Die Radialkanäle 45 des Membranträgers 4 sind mit den Radialkanälen 5 des Hüllkörpers ausberichtet und die zentrale Durchgangsöffnung 41 des Membranträgers 4 ist mit dem Axialkanal 6 des Hüllkörpers ausgerichtet und bilden zusammen einen Luftkanal 5, 6, 45, 41. Die Breite der Radialkanäle 45 des Membranträgers 4 ist grösser als ihre Höhe. Vorzugsweise ist die Kanalbreite doppelt, insbesondere drei-, vier- oder fünfmal so gross wie die Kanalhöhe. In einer alternativen Ausführungsform ist die Breite der Radialkanäle 45 kleiner als ihre Höhe. Vorzugsweise sind die Querschnitte der Radialkanäle 45 des Membranträgers 4 bezüglich der entsprechenden Querschnitte der Radialkanäle 5 des Hüllkörpers eingeschränkt. D.h. die Breite bzw. die Höhe der Radialkanäle 45 des Membranträgers 4 ist kleiner als die Breite bzw. Höhe der entsprechenden Radialkanäle 5 des Hüllkörpers. Die Radialkanäle 5, 45 können jedoch die gleichen Querschnitte aufweisen. Vorzugsweise sind alle Wände der Radialkanäle 45 des Membranträgers 4 versetzt zu den Wänden der Radialkanäle 5 des Hüllkörpers 1 angeordnet. Es können jedoch auch einige fluchtend und die restlichen versetzt zueinander angeordnet sein. Am oberen Ende wird der Membranträger 4 durch einen Membranträger-Abdeckung 47 begrenzt. Vorzugsweise ist sie geschlossen ausgebildet, sie kann jedoch auch Öffnungen aufweisen, welche durch die Filtermembran-Abdeckung 101 vollständig überdeckt sind. Die Filtermembran-Abdeckung 101 kann in diese Öffnungen hineinragen. Vorzugsweise ist an der Membranträger-Abdeckung 47, auf ihrer Innenseite, eine Ausnehmung 46 angeordnet. Sie bewirkt eine Vergrösserung der Radialkanäle 45 im Innern des Membranträgers 4.

Analog zur Figur 3, werden die in der Figur 8 quer verlaufenden Radialkanäle 45, 5 aus der Richtung der linken Öffnung 50 mit einem Gas durchströmt, so wird Gas aus den quer zu diesen Kanälen verlaufenden Radialkanälen 45, 5 und der Durchgangsöffnung 41 angesogen. Dies bewirkt, dass Schmutz oder Flüssigkeiten, welche sich auf der Filtermembran 3 befinden zusammen mit dem Gas abgeführt werden.

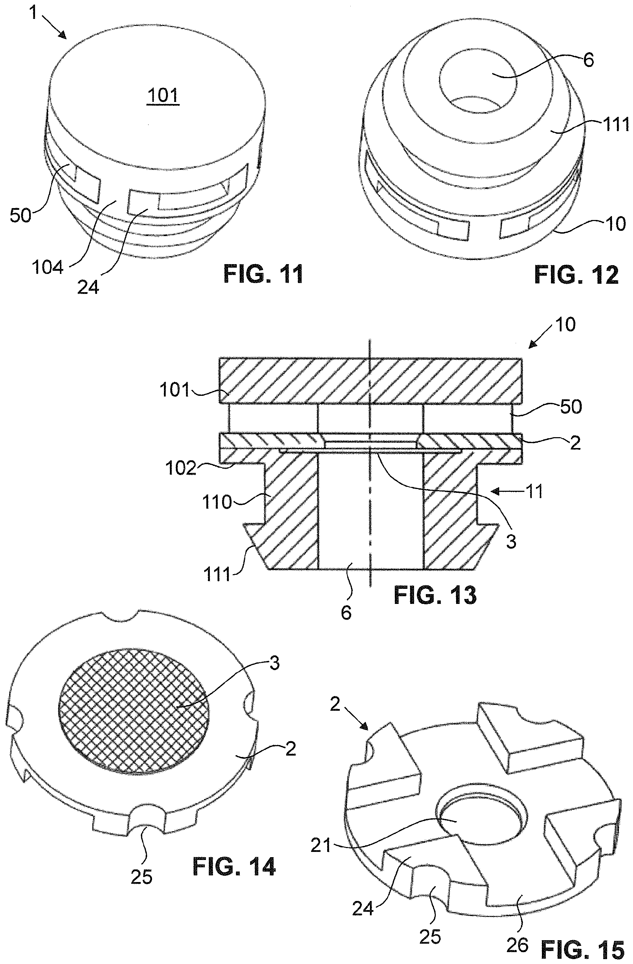

Die Figuren 11 bis 15 zeigen eine dritte Ausführungsform des erfindungsgemässen Druckausgleichselements. In dieser Variante ist der Membranträger 2 als Hartkomponente und der Kopfteil 10 sowie der Halsteil 11 sind als Weichkomponente ausgeführt.

Der Membranträger 2 weist einen Grundkörper in Form einer planparallelen Platte 26 auf mit einer Durchgangsöffnung 21. Auf der Oberseite der Platte 26, d.h. dem Kopfteil 10 zugewandt, sind Abstandhalter 24 angeformt. Sie sind beispielweise als Kreissegmente ausgebildet, wobei sie an ihrem äusseren Umfang eine teilzylinderförmige Einbuchtung 25 aufweisen. Die Spitzen der Kreissegmente enden vorzugsweise beabstandet von der Durchgangsöffnung 21.

Die Platte 26 des Membranträgers 2 weist vorzugsweise dieselbe Grösse auf wie eine obere, dem Kopfteil 10 zugewandte Auflagefläche des Halsteils 11, auf welcher die Platte 26 aufliegt. Vorzugsweise bildet die genannte Auflagefläche einen Kreis und die Platte 26 einen Kreis mit Ausnahme der genannten Ausnehmungen 25.

Die Membran 3 ist vorzugsweise kleiner ausgebildet als die Platte 26, überdeckt jedoch mindestens die Durchgangsöffnung 21. Die Membran 3 ist vorzugsweise auf der dem Kopfteil 10 abgewandten Seite der Platte 26 auf dieser befestigt.

Wie in den Figuren 11 und 12 gut erkennbar ist, ist der Kopfteil 10 über den Membranträger 2 aufgespritzt, wobei er im Bereich der Ausnehmungen 25 des Membranträgers 2 Stege 104 bildet, welche die Filtermembranabdeckung 101 mit dem Halsteil 11 verbindet. Membranteil 2 und Kopfteil 10 bilden wiederum gemeinsam Öffnungen 50 für die Luftkanäle.

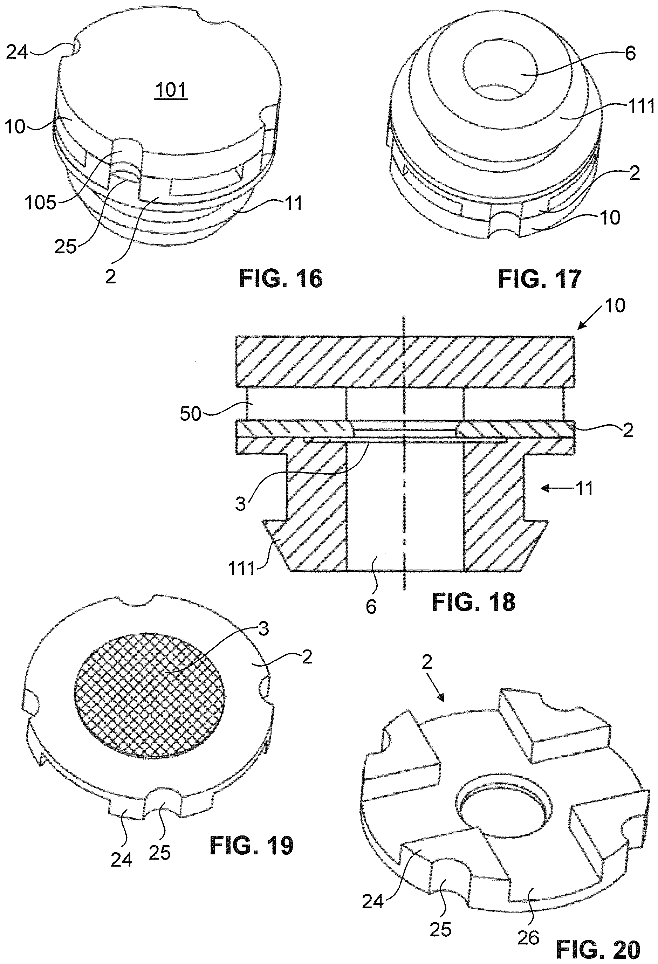

Die Figuren 16 bis 20 zeigen eine vierte Ausführungsform des erfindungsgemässen Druckausgleichselements. In dieser Variante sind der Kopfteil 10 und der Membranträger 2 als Hartkomponente und der Halsteil 11 als Weichkomponente ausgeführt. Der Hüllkörper besteht aus Kopfteil 10, Membranträger 2 und Halsteil 11 und ist somit mehrteilig ausgebildet.

Der Membranträger 2 weist dieselbe Form auf wie im Ausführungsbeispiel gemäss den Figuren 11 bis 15. Vorzugsweise wird der Halsteil 11 auf die Unterseite des Membranträgers 2 aufgespritzt oder der Membranträger 2 wird auf den Halsteil 11 aufgeklebt oder mit ihm verschweisst. Der Kopfteil 10 wird auf den Membranträger aufgespritzt.

Allen Ausführungsformen gemeinsam ist somit, dass die Filtermembran mit dem Hüllkörper umspritzt wird und dass die Abdeckung, welche die Membran schützt, in ihrer Gebrauchslage gespritzt wird. Dabei kann die Membran alleine oder auf einem Träger angeordnet in eine Spritzgussform eingelegt und anschliessend mit dem Hüllkörper umspritzt werden.

Das erfindungsgemässe Druckausgleichselement mit Filtermembran ermöglicht eine einfache und kostengünstige Herstellung und schützt die Filtermembran gegen die direkte Einwirkung von Spritzwasser und äusseren mechanischen Einflüssen.

**BEZUGSZEICHENLISTE**

| | | | |
|---|---|---|---|
| 1 | Hüllkörper | 25 | Ausnehmung |
| 10 | Kopfteil | 26 | Platte |
| 100 | Hüllkörper- Auflagebereich | 3 | Membran |
| 101 | Filtermembran- Abdeckung | 4 | Membranträger |
| 102 | Auflagefläche | 41 | Durchgangsöffnung |
| 103 | Membran- Auflagefläche | 42 | Auflagefläche |
| 104 | Ausnehmung | 43 | Kanalseitige Fläche |
| 11 | Halsteil | 44 | Auflageflansch |
| 110 | Halsbereich | 45 | Membranträger-Radialkanal |
| 111 | Rückhaltebereich | 46 | Ausnehmung |
| 2 | Membranträger | 47 | Membranträger-Abdeckung |
| 21 | Durchgangsöffnung | 5 | Radialkanal |
| 22 | Auflagefläche | 50 | Öffnung |
| 23 | Kanalseitige Fläche | 6 | Axialkanal |
| 24 | Abstandhalter | | |

## Patentansprüche

1. Luftdurchlässiges Druckausgleichselement mit einem selbstdichtenden Hüllkörper (1) und einer darin eingelegten Filtermembran (3), welche mit mindestens einem Teil des Hüllkörpers (1) mindestens auf zwei Seiten umspritzt ist und von einer Filtermembran-Abdeckung (101) des Hüllkörpers (1) überdeckt ist, **dadurch gekennzeichnet, dass** die Filtermembran-Abdeckung (101) in ihrer Gebrauchsposition gespritzt ist.

2. Druckausgleichselement gemäss Anspruch 1, wobei der Hüllkörper (1) radial über seinen Umfang verteilte Öffnungen (50) aufweist, welche mit dem Innenraum des Hüllkörpers (1) einen Luftkanal (5, 6) bilden.

3. Druckausgleichselement gemäss Anspruch 2, wobei die Filtermembran (3) den Luftkanal (5, 6) des Hüllkörpers (1) in mindestens einen Radialkanal (5) und einen Axialkanal (6) unterteilt.

4. Druckausgleichselement gemäss einem der Ansprüche 1 bis 3, wobei die Filtermembran (3) auf einem Membranträger (2, 4) angeordnet ist und wobei der Membranträger (2, 4) selber einen Teil des Luftkanals (5, 6) bildet.

5. Druckausgleichselement gemäss Anspruch 4, wobei der Membranträger (2, 4) Teil des Hüllkörpers (1) bildet.

6. Druckausgleichselement nach Anspruch 1, wobei der Hüllkörper (1) einstückig ausgebildet ist, wobei die Filtermembran (3) auf allen Seiten mit dem Hüllkörper (1) umspritzt ist und wobei die Filtermembran (3) vom gesamten Hüllkörper (1) umspritzt ist.

7. Druckausgleichselement gemäss einem der Ansprüche 4 bis 6, wobei der Membranträger (2) einstückig ausgebildet ist.

8. Druckausgleichselement gemäss einem der Ansprüche 4 bis 7, wobei die Auflagefläche (22) der Filtermembran (3) auf einer dem mindestens einen Radialkanal (5) abgewandten Seite des Membranträgers (2, 4) angeordnet ist.

9. Druckausgleichselement gemäss einem der Ansprüche 4 bis 8, wobei der Membranträger (4) radial über seinen Umfang verteilte Öffnungen aufweist, welche mit dem Innenraum des Membranträgers einen Luftkanal (41, 45) bilden, wobei der Luftkanal (41, 45) des Membranträgers mindestens einen Radialkanal (45) und einen Axialkanal (41) aufweist und wobei die Radialkanäle (45) bzw. der Axialkanal (41) des Membranträgers mit den Radialkanälen (5) bzw. mit dem Axialkanal (6) des Hüllkörpers (1) ausgerichtet sind.

10. Druckausgleichselement gemäss einem der Ansprüche 4 bis 9, wobei der Querschnitt des mindestens einen Radialkanals (45) des Membranträgers (4) bezüglich des mindestens einen Querschnitts des Radialkanals (5) des Hüllkörpers eingeschränkt ist.

11. Druckausgleichselement gemäss einem der Ansprüche 4 bis 10, wobei eine kanalseitige Fläche (23, 43) des Membranträgers (2, 4), welche einen Teil des Luftkanals (5, 6, 45, 41) bildet, fluchtend mit einer Wand eines Hüllkörper-Radialkanals (5) angeordnet ist.

12. Druckausgleichselement gemäss einem der Ansprüche 4 bis 10, wobei eine kanalseitige Fläche (23, 43) des Membranträgers (2, 4), welche einen Teil des Luftkanals (5, 6, 45, 41) bildet, versetzt zu einer Wand eines Hüllkörper-Radialkanals (5) angeordnet ist.

13. Druckausgleichselement gemäss einem der Ansprüche 4 bis 12, wobei der Axialkanal (41) des Membranträgers (4) in einem zentralen Kanalbereich (46) des Membranträgers (4) über eine kanalseitige Fläche (43) des mindestens einen Radialkanals (45) des Membranträgers (4) ragt.

14. Druckausgleichselement gemäss einem der Ansprüche 1 bis 13, wobei die Filtermembran (3) in einer umlaufenden Vertiefung des Hüllkörpers (1) angeordnet ist.

15. Druckausgleichselement gemäss einem der Ansprüche 1 bis 14, wobei der Hüllkörper (1) aus einem hydrophoben Material, vorzugsweise aus Silikon besteht.

16. Druckausgleichselement gemäss einem der Ansprüche 1 bis 14, wobei die Filtermembran (3) luftdurchlässig und flüssigkeitsundurchlässig ausgebildet ist, und vorzugsweise eine hydrophobe Track-Etched Membran ist oder aus einem hydrophoben, porösen Material, vorzugsweise aus Polytetrafluoräthylen (PTFE) oder aus hydrophobierten Copolymeren besteht.

17. Druckausgleichselement gemäss einem der Ansprüche 1 bis 14, wobei der Membranträger (2) aus einem unflexiblen Material, vorzugsweise aus einem korrosionsbeständigen Metall, aus einem Kunststoff oder einem verstärkten Kunststoff besteht.

18. Druckausgleichselement gemäss einem der Ansprüche 1 bis 17, wobei die Abdeckung (101) geschlossen ausgebildet ist.

19. Verfahren zur Herstellung eines Druckausgleichselements gemäss einem der Ansprüche 1 bis 18, aufweisend die folgenden Schritte:
- Einlegen der Filtermembran (3) in die Spritzform,
- Schliessen der Spritzform,
- Spritzen des Hüllkörpers (1) bei gleichzeitigem Umspritzen der Membran (3) und bei gleichzeitigem Spritzen der Filtermembran-Abdeckung (101) in ihrer Gebrauchsposition,
- Öffnen der Spritzform und
- Entnehmen des Druckausgleichselements.

20. Verfahren zur Herstellung eines Druckausgleichselements gemäss Anspruch 19, wobei die Filtermembran (3), vor dem Einlegen in die Spritzform, auf einem Membranträger (2, 4) angebracht wird.

## Claims

1. Air-permeable pressure equalizing element with a self-sealing enveloping body (1), and, inserted therein, a filter membrane (3), which is encapsulated at least on two sides by at least part of the enveloping body (1) and is covered over by a filter-membrane covering (101) of the enveloping body (1), **characterized in that** the filter-membrane covering (101) is moulded in its position for use.

2. Pressure equalizing element according to Claim 1, the enveloping body (1) having, distributed radially over its circumference, openings (50) which form an air duct (5, 6) with the interior space of the enveloping body (1).

3. Pressure equalizing element according to Claim 2, the filter membrane (3) dividing the air duct (5, 6) of the enveloping body (1) into at least one radial duct (5) and an axial duct (6).

4. Pressure equalizing element according to one of Claims 1 to 3, the filter membrane (3) being arranged on a membrane carrier (2, 4) and the membrane carrier (2, 4) itself forming part of the air duct (5, 6).

5. Pressure equalizing element according to Claim 4, the membrane carrier (2, 4) forming part of the enveloping body (1).

6. Pressure equalizing element according to Claim 1, the enveloping body (1) being formed in one piece, the filter membrane (3) being encapsulated on all sides by the enveloping body (1) and the filter membrane (3) being encapsulated by the entire enveloping body (1).

7. Pressure equalizing element according to one of Claims 4 to 6, the membrane carrier (2) being formed in one piece.

8. Pressure equalizing element according to one of Claims 4 to 7, the bearing surface (22) of the filter membrane (3) being arranged on a side of the membrane carrier (2, 4) that is facing away from the at least one radial duct (5).

9. Pressure equalizing element according to one of Claims 4 to 8, the membrane carrier (4) having, distributed radially over its circumference, openings which form an air duct (41, 45) with the interior space of the membrane carrier, the air duct (41, 45) of the membrane carrier comprising at least one radial duct (45) and an axial duct (41) and the radial ducts (45) and the axial duct (41) of the membrane carrier being respectively aligned with the radial ducts (5) and the axial duct (6) of the enveloping body (1).

10. Pressure equalizing element according to one of Claims 4 to 9, the cross section of the at least one radial duct (45) of the membrane carrier (4) being restricted with respect to the at least one cross section of the radial duct (5) of the enveloping body.

11. Pressure equalizing element according to one of Claims 4 to 10, a duct-side face (23, 43) of the membrane carrier (2, 4) that forms part of the air duct (5, 6, 45, 41) being arranged in line with a wall of a radial duct (5) of the enveloping body.

12. Pressure equalizing element according to one of Claims 4 to 10, a duct-side face (23, 43) of the membrane carrier (2, 4) that forms part of the air duct (5, 6, 45, 41) being arranged offset in relation to a wall of a radial duct (5) of the enveloping body.

13. Pressure equalizing element according to one of Claims 4 to 12, the axial duct (41) of the membrane carrier (4) in a central duct region (46) of the membrane carrier (4) protruding beyond a duct-side face (43) of the at least one radial duct (45) of the membrane carrier (4).

14. Pressure equalizing element according to one of Claims 1 to 13, the filter membrane (3) being arranged in a peripheral depression of the enveloping body (1).

15. Pressure equalizing element according to one of Claims 1 to 14, the enveloping body (1) consisting of a hydrophobic material, preferably of silicone.

16. Pressure equalizing element according to one of Claims 1 to 14, the filter membrane (3) being of an air-permeable and liquid-impermeable form, and preferably being a hydrophobic track-etched membrane consisting of a hydrophobic, porous material, preferably of polytetrafluoroethylene (PTFE) or of hydrophobized copolymers.

17. Pressure equalizing element according to one of Claims 1 to 14, the membrane carrier (2) consisting of an inflexible material, preferably of a corrosion-resistant metal, of a plastic or a reinforced plastic.

18. Pressure equalizing element according to one of Claims 1 to 17, the covering (101) being of a closed form.

19. Method for producing a pressure equalizing element according to one of Claims 1 to 18, comprising the following steps:
- placing the filter membrane (3) in the injection mould,
- closing the injection mould,
- moulding the enveloping body (1) while at the same time encapsulating the membrane (3) and while at the same time moulding the filter-membrane covering (101) in its position for use,
- opening the injection mould and
- removing the pressure equalizing element.

20. Method for producing a pressure equalizing element according to Claim 19, the filter membrane (3) being attached on a membrane carrier (2, 4) before being placed into the injection mould.

## Revendications

1. Élément d'équilibrage de pression perméable à l'air, comprenant un corps d'enveloppe auto-étanche (1) et une membrane de filtre (3) insérée dans celui-ci, laquelle est surmoulée avec au moins une partie du corps d'enveloppe (1) sur au moins deux côtés et est recouverte par un recouvrement de membrane de filtre (101) du corps d'enveloppe (1), **caractérisé en ce que** le recouvrement de membrane de filtre (101) est pulvérisé dans sa position d'utilisation.

2. Élément d'équilibrage de pression selon la revendication 1, dans lequel le corps d'enveloppe (1) présente des ouvertures (50) réparties radialement sur sa périphérie, lesquelles forment un conduit d'air (5, 6) avec l'espace interne du corps d'enveloppe (1).

3. Élément d'équilibrage de pression selon la revendication 2, dans lequel la membrane de filtre (3) divise le conduit d'air (5, 6) du corps d'enveloppe (1) en au moins un conduit radial (5) et un conduit axial (6).

4. Élément d'équilibrage de pression selon l'une quelconque des revendications 1 à 3, dans lequel la membrane de filtre (3) est disposée sur un support de membrane (2, 4) et le support de membrane (2, 4) forme lui-même une partie du conduit d'air (5, 6).

5. Élément d'équilibrage de pression selon la revendication 4, dans lequel le support de membrane (2, 4) forme une partie du corps d'enveloppe (1).

6. Élément d'équilibrage de pression selon la revendication 1, dans lequel le corps d'enveloppe (1) est réalisé d'une seule pièce, la membrane de filtre (3) étant surmoulée de tous les côtés avec le corps d'enveloppe (1) et la membrane de filtre (3) étant surmoulée par l'ensemble du corps d'enveloppe (1).

7. Élément d'équilibrage de pression selon l'une quelconque des revendications 4 à 6, dans lequel le support de membrane (2) est réalisé d'une seule pièce.

8. Élément d'équilibrage de pression selon l'une quelconque des revendications 4 à 7, dans lequel la surface d'appui (22) de la membrane de filtre (3) est disposée sur un côté du support de membrane (2, 4) opposé à l'au moins un conduit radial (5).

9. Élément d'équilibrage de pression selon l'une quelconque des revendications 4 à 8, dans lequel le support de membrane (4) présente des ouvertures réparties radialement sur sa périphérie, lesquelles forment avec l'espace interne du support de membrane un conduit d'air (41, 45), le conduit d'air (41, 45) du support de membrane présentant au moins un conduit radial (45) et un conduit axial (41) et les conduits radiaux (45), respectivement le conduit axial (41), du support de membrane étant alignés avec les conduits radiaux (5), respectivement le conduit axial (6), du corps d'enveloppe (1).

10. Élément d'équilibrage de pression selon l'une quelconque des revendications 4 à 9, dans lequel la section transversale de l'au moins un conduit radial (45) du support de membrane (4) est limitée par rapport à l'au moins une section transversale du conduit radial (5) du corps d'enveloppe.

11. Élément d'équilibrage de pression selon l'une quelconque des revendications 4 à 10, dans lequel une surface du côté du conduit (23, 43) du support de membrane (2, 4), qui forme une partie du conduit d'air (5, 6, 45, 41), est disposée en affleurement avec une paroi d'un conduit radial (5) du corps d'enveloppe.

12. Élément d'équilibrage de pression selon l'une quelconque des revendications 4 à 10, dans lequel une surface du côté du conduit (23, 43) du support de membrane (2, 4), qui forme une partie du conduit d'air (5, 6, 45, 41), est disposée de manière décalée par rapport à une paroi d'un conduit radial (5) du corps d'enveloppe.

13. Élément d'équilibrage de pression selon l'une quelconque des revendications 4 à 12, dans lequel le conduit axial (41) du support de membrane (4) pénètre dans une région de conduit centrale (46) du support de membrane (4) par le biais d'une surface du côté du conduit (43) de l'au moins un conduit radial (45) du support de membrane (4).

14. Élément d'équilibrage de pression selon l'une quelconque des revendications 1 à 13, dans lequel la membrane de filtre (3) est disposée dans un renfoncement périphérique du corps d'enveloppe (1) .

15. Élément d'équilibrage de pression selon l'une quelconque des revendications 1 à 14, dans lequel le corps d'enveloppe (1) se compose d'un matériau hydrophobe, de préférence de silicone.

16. Élément d'équilibrage de pression selon l'une quelconque des revendications 1 à 14, dans lequel la membrane de filtre (3) est réalisée de manière perméable à l'air et imperméable aux liquides, et de préférence est une membrane hydrophobe obtenue par track-etching ou se compose d'un matériau hydrophobe poreux, de préférence de polytétrafluoroéthylène (PTFE) ou de copolymères rendus hydrophobes.

17. Élément d'équilibrage de pression selon l'une quelconque des revendications 1 à 14, dans lequel le support de membrane (2) se compose d'un matériau non flexible, de préférence d'un métal résistant à la corrosion, d'un plastique ou d'un plastique renforcé.

18. Élément d'équilibrage de pression selon l'une quelconque des revendications 1 à 17, dans lequel le recouvrement (101) est réalisé sous forme fermée.

19. Procédé de fabrication d'un élément d'équilibrage de pression selon l'une quelconque des revendications 1 à 18, présentant les étapes suivantes :
- insertion de la membrane de filtre (3) dans le moule de pulvérisation,
- fermeture du moule de pulvérisation,
- pulvérisation du corps d'enveloppe (1) avec surmoulage simultané de la membrane (3) et avec pulvérisation simultanée du recouvrement de membrane de filtre (101) dans sa position d'utilisation,
- ouverture du moule de pulvérisation et
- enlèvement de l'élément d'équilibrage de pression.

20. Procédé de fabrication d'un élément d'équilibrage de pression selon la revendication 19, dans lequel la membrane de filtre (3), avant l'insertion dans le moule de pulvérisation, est appliquée sur un support de membrane (2, 4).
